# EUROPEAN PATENT APPLICATION

(11) **EP 2 202 326 A1**
(43) Date of publication of application: **30.06.2010**
(21) Application number: 08836473.2
(22) Date of filing: 02.10.2008
(51) Int. Cl.: C22C 9/06, H01L 23/48, C22F 1/00, C22F 1/08

(54) **COPPER ALLOY PLATE MATERIAL FOR ELECTRIC AND ELECTRONIC COMPONENTS**

(30) Priority: 03.10.2007 JP 2007260397
(71) Applicant: The Furukawa Electric Co., Ltd., Chiyoda-ku Tokyo 100-8322 (JP)
(72) Inventor: MIHARA, Kuniteru, Tokyo 100-8322 (JP); NAKANO, Junsuke, Tokyo 100-8322 (JP); SUGAHARA, Chikahito, Tokyo 100-8322 (JP); UNO, Takeo, Tokyo 100-8322 (JP)
(74) Representative: Forstmeyer, Dietmar
(86) International application number: PCT/JP2008/067948
(87) International publication number: WO 2009/044822

(57) **Abstract**

An copper alloy strip material for electrical/electronic components according to the present invention is **characterized in that** such the copper alloy strip material for electrical/electronic components includes: Ni as between 1.5 mass% and 4.0 mass%; Si as between 0.3 mass% and 1.5 mass%; and the balance being Cu and unavoidable impurities, wherein a mean roughness Ra of a surface roughness is not larger than 0.3 µm regarding the strip in a direction as right angle to a direction of a rolling therefor, a maximum height Ry thereof is not higher than 3.0 µm regarding the same therein, and there is positioned a peak position regarding a frequency curve, that represents a concave component of the surface roughness and/or a convex component thereof, at the plus side (the side for the convex component) comparing to an average value of the curve for meaning the surface roughness.

## Description

### Technical field

The present invention relates to a copper alloy strip material.

### Background art

So far, as a material for an electrical machinery and apparatus and for electronic equipment in general, there is widely made use of a copper-based material, as that is superior in electrical conduction property and in thermal conductivity, such as phosphor bronze, tombac, brass, or the like, in addition to a iron-based material.
In recent years, there becomes to be further required for packaging as a smaller in size of the electrical machinery and apparatus and of the electronic equipment, for lighter in weight thereof, and for packaging as higher density according thereto. And then thereby there becomes to be required a variety of properties for such the copper-based material to be applied thereto. Here, it is able to be provided as a principal property therefor, such as a strength thereof, an electrical conductivity thereof, a withstand stress and relaxation characteristic, a bending workability, a pressing workability, or the like, and then in addition thereto, it is able to be provided a surface property thereon as well, such as ability of plating thereon, a solder wettability thereon, or the like.

Moreover, among such the above mentioned materials, an alloy which is so called a Corson alloy, that there is designed to be added Ni and Si into Cu, and then that there becomes to be formed a precipitate to be configured by making use of such the Ni and the Si therein for enhancing a strength thereof, has a potential to be enhanced such the strength thereof as extremely higher comparing to any other alloys of precipitation type as there are existing a plurality thereof. And then thereby the same has already been made use for some alloys on the market as well, such as for the CDA70250 that is the alloy of registry at the CDA (Copper Development Association), or the like.

Further, regarding such the copper alloy for the electronic equipments, there are provided the following example as heretofore known that there is specified a relative roughness on a surface thereof regarding such the Corson alloy as mentioned above.
Here, the Japanese Patent Application Publication No. S63(1988)-324782 and the Japanese Patent Application Publication No. H11(1999)-124698 are individually characterized in that it becomes able to be performed a connection of such as a gold wire or the like thereby to the copper alloy without performing a plating thereon regarding a process for producing a semiconductor with making use of the lead frame. Still further, the application according to the Japanese Patent Application Publication No. 2000-288991 is for a foil, and then the same is the technology that is made use for an FPC (a flexible printed circuit). Still further, the application according to the Japanese Patent Application Publication No. 2001-100581 is defined the roughness in intermediate process. Still further, there is disclosed the improvement of the solder wettability according to such the Japanese Patent Application Publication No. H11-124698, however, there is not disclosed any embodiments at all, such as an improvement as how much degree of magnitude thereby. Still further, in the case of the application for the lead frame, there are disclosed the several examples, that there is performed the assessment of the adherence regarding the oxide film layer thereon, for the object to improve the adherence onto the resin mold.
Still further, according to such the above mentioned patent documents, there is specified by making use of such as a mean roughness (Ra) of an average line regarding a relative roughness on a surface thereof, a maximum height (Ry) thereof, or the like. However, there is not disclosed any relationship at all therein to a surface property, such as the ability of plating thereon, the solder wettability thereon, or the like, regarding each of a convex component and a concave component in such the relative roughness on the surface thereof respectively.

Still further, regarding the Cu-Ni-Si alloy (the Corson alloy), there becomes to be improved the strength thereof and the electrical conductivity thereof, by performing a heat treatment therefor, and then due to occurring the precipitation of the Ni and the Si thereby as an intermetallic compound of Ni-Si therein, that are the components to be contained therein. However, there is designed to be performed such the heat treatment therefor at relatively higher temperature in general, such as between 400°C and 600°C. Still further, there is designed to be performed the same with an amount of time therefor as a long period of time as well, such as between 0.5 hour and five hours. Hence, the Si in a vicinity of the surface of such the material becomes to combine thereby with oxygen as a very small amount thereof at an inside of a furnace for such the heat treatment, and then thereby there becomes to be formed a compound of silicon oxides therein.
Still further, such the Si in the vicinity of the surface thereof cannot help but be oxidized as similar thereto, because there is designed to be performed at a temperature to be as further higher regarding a solution heat treatment therefor (there may be a case where such the treatment is referred to as a treatment for re-crystallization thereof, or a treatment for homogenization thereof).
Still further, there is heretofore known that there becomes to be deteriorated excessively regarding such as the ability of plating thereon, the solder wettability thereon, or the like, in a case where there are remained such the compounds of silicon oxides even in the final product. And then thereby there is designed to be performed a process for removing the compound of silicon oxides in the vicinity of the surface thereof before finishing to be produced as such the final product.
Still further, for removing such the compounds of silicon oxides, there are a lot of cases where there is made use of an acid dissolution (a solution of a hydrofluoric acid based, a mixed acid solution of a dilute sulfuric acid and of a hydrogen peroxide solution) therefor. Still further, there is designed to be removed such the compound with performing a continuous strip leaping normally, that a strip of a coil shape is soaked into a bath to be filled with such the solution. However, it is necessary to design an amount of time for soaking thereinto as sufficiently long, for removing as sufficiently such the compound of silicon oxides in the vicinity of the surface thereof. And then therefor, due to the point of views of such as the total cost therefor, a management of such the acid solutions, or the like in general, there is designed to be performed the removal of such the compound of silicon oxides, that is adhered onto the surface thereof, as physically and as mechanically therefor, with making use of a substance, that is so called as such as a brush, a buff, or the like.
Still further, in the case of rubbing the surface of the strip by making use of such as the brush, the buff, or the like, that are finished to be performed the acid dissolution therefor, there becomes to be generated a concave thereon and/or a convex thereon. And then thereby such the Corson alloy cannot help but become to have a surface thereof with having a relative roughness as relatively larger (that is approximately equal to be rough) even at an intermediate process for producing thereof. Furthermore, it is heretofore known that there becomes to be deteriorated frequently the ability of plating thereof and the solder wettability thereof in the case where such the concave thereon and/or the convex thereon is relatively large.

### Disclosure of the invention

Moreover, such the subjects as mentioned above have not been considerable for such as the conventional substance to be made use for the lead frame or the like. However, in recent years, there becomes to be increased a requirement of such as an environment resistant property under an environment of a higher temperature and of a higher humidity, a correspondence to the lead free soldering, or the like, and then according to any one of the technologies as disclosed in the above mentioned each of the Japanese Patent Application Publications, there becomes to be happened that it is not able to satisfy the property of such as the ability of plating thereon, the solder wettability thereon, or the like. Therefore, with having regard to such the points at issue as mentioned above, and then here the subjects of the present invention are to provide an copper alloy, that is superior in the ability of plating thereon and the solder wettability thereon even under an environment for making use thereof as severe therefor, and that is applicable as preferred to such as a lead frame for an electrical machinery and apparatus and for an electronic equipment, a connector therefor, a material for a terminal therein, or the like.

Here, the present inventors have investigated deeply regarding such the copper alloy, that is applicable as preferred to the application of an electrical and an electronic components, have been directing their attention to a relative roughness on a surface of a strip to be produced by making use of such the copper alloy, and then there are found out a relationship that there becomes to be improved the ability of plating thereon of the material therefor and the solder wettability thereon of the material therefor in a case where a peak position regarding a frequency curve, that presents a concave component of a surface roughness and/or a convex component thereof, positions at the plus side (the side for the convex component thereof) comparing to an average value of the curve for meaning the surface roughness thereof (a position as zero regarding such the frequency curve) . Moreover, the further examinations are progressed therefor, and then it becomes able to complete the present invention hereby.
That is to say, according to the present invention, it becomes able to obtain a Cu-Ni-Si alloy (a Corson copper), that is superior in surface quality thereof.

That is to say, according to the present invention, it becomes able to be provided alloy strip materials as defined below.
1. A first aspect regarding a copper alloy strip material for electrical/electronic components according to the present invention is characterized in that such the copper alloy strip material for electrical/electronic components includes: Ni as between 1.5 mass% and 4.0 mass%; Si as between 0.3 mass% and 1.5 mass%; and the balance being Cu and unavoidable impurities, wherein a mean roughness Ra of a surface roughness is not larger than 0.3 µm regarding the strip in a direction as right angle to a direction of a rolling therefor, a maximum height Ry thereof is not higher than 3.0 µm regarding the same therein, and there is positioned a peak position regarding a frequency curve, that represents a concave component of the surface roughness and/or a convex component thereof, at the plus side (the side for the convex component) comparing to an average value of the curve that means the surface roughness thereof.
2. A second aspect regarding a copper alloy strip material for electrical/electronic components according to the present invention is characterized in that such the copper alloy strip material for electrical/electronic components includes: Co as between 0.5 mass% and 2.0 mass%; Ni and Co in total as between 1.5 mass% and 4.0 mass%; Si as between 0.3 mass% and 1.5 mass%; and the balance being Cu and unavoidable impurities, wherein a mean roughness Ra of a surface roughness is not larger than 0.3 µm regarding the strip in a direction as right angle to a direction of a rolling therefor, a maximum height Ry thereof is not higher than 3.0 µm regarding the same therein, and there is positioned a peak position regarding a frequency curve, that represents a concave component of the surface roughness and/or a convex component thereof, at the plus side (the side for the convex component) comparing to an average value of the curve that means the surface roughness thereof.
3. A third aspect regarding a copper alloy strip material for electrical/electronic components according to the present invention is characterized in that regarding such the copper alloy strip material for electrical/electronic components as described in the above mentioned first or the second aspect, the copper alloy includes at least any one of elements, that is selected from a group to be comprised of Sn, Zn, Cr and Mg, as between 0.005 mass% and 1.0 mass% in total therefor.

The above and other aspects and advantages according to the present invention will be further clarified by the following description, with reference to the drawings to be attached as properly therefor.

### Brief description of the drawings

FIG. 1 is a drawing to be excerpted from the JIS(B0601).
FIG. 2 is a relative roughness chart showing an example of a relative roughness on a surface thereof.
FIG. 3 is a graph showing a result that there is made an analysis of the relative roughness chart as shown in FIG. 2, with making use of a concave component therein and/or a convex component therein.

### Best mode for carrying out the invention

An embodiment to be preferred for a copper alloy strip material according to the present invention will be described in detail below.
First of all, a composition of an copper alloy to be made use for such the copper alloy material according to the present invention will be described in detail below.
Here, there is designed a content of Ni therein to be as between 1.5 mass% and 4.0 mass%, and it is further preferable to be as between 2.0 mass% and 3.0 mass%. Moreover, there is designed a content of Si therein to be as between 0.3 mass% and 1.5 mass%, and it is further preferable to be as between 0.4 mass% and 0.7 mass%. Further, regarding a mass ratio between that of Ni therein and that of Si therein, there is no limitation in particular thereto, however, it is desirable to be as between 3.5/1 and 5.0/1 for the Ni/Si therein respectively.
Still further, regarding the Ra of such the copper alloy strip material, there is designed to be as not larger than 0.3 µm, and it is preferable to be as not larger than 0.2 µm. Still further, it is further preferable for such the Ra to be as small as possible, and there is no limitation in particular for a lower limit thereof, however, such the value is not smaller than 0.01 µm in normal. Still further, regarding the Ry thereof, there is designed to be as not higher than 3. 0 µm, and it is preferable to be as not higher than 2.0 µm. Still further, it is further preferable for such the Ry to be as low as possible, and there is no limitation in particular for a lower limit thereof, however, such the value is not lower than 1.0 µm in normal.
Still further, according to the copper alloy strip material regarding the present invention, there is designed to be controlled the peak position regarding a frequency curve, that presents the concave component of the surface roughness and/or the convex component thereof, to be positioned at the plus side (the side for the convex component thereof), comparing to the average value of the curve for meaning the surface roughness thereof (the position as zero regarding such the frequency curve). Still further, the copper alloy strip material according to the present invention means a rolled strip to be formed by making use of a rolling mill roll, and there is no limitation in particular for such as a thickness thereof, for a width thereof, or the like thereof. Still further, the same means that includes not only such the strip shape but also a bar shape as well.
Still further, according to a process for producing such the copper alloy material for electrical/electronic components regarding the present invention, first of all, there are performed a solution heat treatment, a hot rolling and then a cold rolling in the usual manner for an alloyed ingot, that is produced beforehand in the usual manner. And then thereafter, there is designed to be performed a heat treatment therefor, as desirably at between 400°C and 550°C, and as desirably for between one hour and four hours. Next, there is designed to be performed an acid cleaning therefor. Still further, there is no limitation in particular regarding such the acid cleaning therefor, however, it is desirable therefor to be performed the cleaning therefor with making use of the dilute acid with an amount of time for soaking thereinto as between five seconds and one hundred seconds, and it is further preferable therefor to be as between ten seconds and thirty seconds.
Still further, regarding such the dilute acid therefor, it is able to be provided such as a dilute sulfuric acid with having a concentration as not higher than 20%, a dilute hydrochloric acid therewith, an aqua fortis therewith, or the like. Still further, regarding each of such the dilute acids therefor, it is desirable to be made use each thereof with having the concentration as not higher than 10%.
Still further, it may be available to perform a treatment to be degreased for such the rolled strip after performing the process of such the above mentioned heat treatment therefor. Still further, regarding such the treatment to be degreased therefrom, it is able to perform by making use of a method for soaking into any one of a variety of cleaning solutions, such as an organic solvent of such as hexane, acetone, toluene, or the like, an aqueous solution of alkaline, such as sodium hydroxide, calcium hydroxide, or the like.
Still further, according to such the acid cleaning therefor and/or the treatment to be degreased therefrom, it becomes able to design to be controlled the peak value regarding the frequency curve, that presents the concave component of the surface roughness and/or the convex component thereof as an objet according to the present invention, to be positioned at the plus side, comparing to the average value of the curve for meaning the surface roughness thereof (the position as zero regarding such the frequency curve).
Still further, according to the present invention, there is designed to be performed a finishing rolling therefor at next thereto. Still further, there is no limitation in particular regarding a rolling reduction rate of such the finishing rolling therefor, and it is desirable therefor to be as not higher than 40%, and it is further preferable therefor to be as between 5% and 40%.

Still further, there is received an effect on the relative roughness of the final product due to a relative roughness of a rolling mill roll to be made use therefor. That is to say, there becomes to be transferred the relative roughness of the rolling mill roll onto the material therefor, and then there is a tendency therein that the larger the relative roughness of the rolling mill roll to be made use therefor is, the larger the relative roughness of such the material to be rolled becomes to be. However, in a case where there is designed to be smaller for such the relative roughness of the rolling mill roll to be made use therefor, there becomes to be minus for a forward slip thereof. And then thereby it cannot help but become a process for rolling thereof under a state as slipped. As a result, there becomes to be affected as negatively onto a work efficiency of rolling therefor, such as a generation of any defect on the surface thereof, a running away of the strip therefrom, or the like.
Furthermore, there is a limitation on the relative roughness to be able to control at the process of the final rolling therefor. And then it is heretofore known as well that in a case of being rolled with a relative roughness of a rolling mill roll to be made use therefor as equivalent to each of therebetween, the smaller the relative roughness of the material is, that is supplied before performing the process of such the final rolling therefor, and the larger the rolling reduction thereof is, the smaller thereby the relative roughness thereon becomes to be.

Here, the present inventors have examined in comprehensive manners regarding such the findings as mentioned above, and then it is found out that there becomes to be changed the ability of plating thereon and the solder wettability thereon, by changing a ratio between the concave component of the relative roughness and the convex component thereof on a strip material. that is to say, it is heretofore known that regarding the surface roughness thereon, there is appeared each of the concave component thereof and the convex component thereof as equally between a central line as a border therefor, that corresponds to an average value of such the components, however, it is found out that it becomes able to be improved the ability of plating thereon and the solder wettability thereon, by changing in an intentional manner for the ratio between such the individual components.
Moreover, there may be effected on the relative roughness of the copper alloy strip material as the product to be objective for the present invention, by the relative roughness of the rolling mill roll at the process of the intermediate cold rolling therefor or that at the process of the finishing rolling therefor as well. Therefore, it is desirable for the surface roughness of the above mentioned rolling mill roll at the process of the intermediate cold rolling therefor to be controlled as the Ra thereof is between 0. 2 µm and 0.6 µm and the Ry thereof is between 2 µm and 6 µm. Further, it is desirable for the relative roughness of the above mentioned rolling mill roll at the process of the finishing rolling therefor to be controlled as the Ra thereof is between 0.02 µm and 0.15 µm and the Ry thereof is between 0.2 µm and 1.5 µm.
Still further, as described above, it is able to change the individual amounts of the concave component and the convex component regarding the relative roughness of the strip material, by changing such as the method for removing the compound of silicon oxides on the surface thereof, the relative roughness of the rolling mill roll, or the like. However, it is not able to control the ratio between the concave component of the relative roughness and the convex component thereof on such the strip material with an accuracy as higher. And then thereby there is remained within a certain limit as only specifying such as the Ra, the Ry, or the like, regarding the relative roughness on the surface thereof according to the above mentioned each of the patent documents.
On the contrary, according to the present invention, in a case of performing a finishing rolling for a material, that there is performed at first as repeatedly the heat treatment therefor and the acid cleaning treatment therefor, and then thereafter that is soaked into the dilute acid (such as an aqueous solution of sulfuric acid as 10% therein or the like) before performing the process of the final rolling therefor (before the process of the finishing rolling therefor), there becomes to be appeared a peak position regarding a frequency curve, that represents the concave component of the surface roughness and/or the convex component thereof, at the plus side (the side for the convex component), comparing to an average value of the curve for meaning the surface roughness (a position as zero regarding such the frequency curve). Still further, as similar thereto, in a case of performing a finishing rolling for a material, that there is to be degreased therefrom beforehand (by being soaked into such as hexane, an organic solvent of such hexane as the principal ingredient therein, or the like, a cleaning solution of hydrocarbon based, or the like), there becomes to be appeared a peak position regarding a frequency curve, that represents the concave component of the surface roughness and/or the convex component thereof, at the plus side (the side for the convex component) as well, comparing to an average value of the curve for meaning the surface roughness (a position as zero regarding such the frequency curve), as similar thereto.
Still further, a chemical state in a vicinity of the surface of such the material before performing the process of the final rolling therefor may have an effect on a state after the process of the final rolling therefor. And then thereby it is able to be surmised that there becomes to be appeared each of such the peak positions regarding the individual frequency curves, that individually represent the concave component of the surface roughness and/or the convex component thereof, at each of the plus side (the individual sides for the convex component), comparing to each of the average value of the individual curves for individually meaning the surface roughness (the individual positions as zero regarding each of such the frequency curves), though there has not yet cleared a cause of such the phenomenon. For example, it is able to be surmised that there becomes to be appeared a difference on the removal of a surface layer thereon, such as an oxide film layer thereon, that is formed at the process of the heat treatment therefor before performing the acid cleaning therefor, a work hardened surface layer thereon, that is formed at the process of the cold rolling therefor before performing the process to be degreased therefrom, or the like. And then thereby it is able to be considered that there may become to be changed a thickness thereon to be removed therefrom, as a very small amount thereof, by making use of such as the acid cleaning therefor, the process to be degreased therefrom, or the like.

Still further, there may be another factor that is caused by the relative roughness of the rolling mill roll at the process of the finishing rolling therefor as well (there is existed both of the concave component and the convex component in the relative roughness of such the roll as well). For example, there becomes to be increased the concave components in such the material therefor in a case where there are a lot of convex components in the relative roughness of such the rolling mill roll to be made use therefor. On the contrary thereto, there becomes to be increased the convex components in such the material therefor in a case where there are a lot of concave components therein of such the rolling mill roll to be made use therefor. That is to say, there becomes to be changed the relative roughness of such the material therefor and each of the components in such the relative roughness thereof (the concave components therein and/or the convex components therein), due to the relative roughness of the rolling mill roll to be made use therefor.
Still further, in a case where the Ra of the relative roughness on the surface of the material for the final product is designed to be as not larger than 0.3 µm and also the Ry thereof as the maximum height thereof is designed to be as not larger than 3.0 µm, it becomes able to judge that there becomes to be obtained the material therefor with having a property to be as superior in the solder wettability thereon and in the ability of plating thereon in the case where there becomes to be appeared the peak position regarding the frequency curve, that represents the concave component in the surface roughness thereof and/or the convex component therein, at the plus side (the side for the convex component), comparing to the average value of the curve for meaning the surface roughness (the position as zero regarding such the frequency curve).

Still further, the meaning of the case where there is existing such the peak position regarding the frequency curve, that represents the concave component in the surface roughness of such the material and/or the convex component therein, as the component at the plus side comparing to the average value of the curve for meaning the surface roughness thereon (the position as zero regarding such the frequency curve) is that regarding a roughness curve therefor (a profile curve) whether there becomes to be increased the convex component therein or there becomes to be decreased the concave component therein, comparing to each of that in an average line therefor to be obtained by making use of a filtered waviness curve therefor.
Furthermore, the solder wettability is a test for examining an amount of time for a molten solder to become getting wet onto a surface of a material therefor, and for examining a change of a load therefor in the period thereof. And, in a case of an alloy that includes Si as a component in such the alloy, such as the Corson alloy or the like, there becomes to be hard to take a roundabout way for such the solder onto any concave part thereon, and then thereby it becomes to be inferior in the solder wettability thereon. Therefore, if there is reduced the concave component thereon, it becomes able to be improved such the solder wettability thereon.
While, according to an electroplating therefor, there becomes to be trapped any hydrogen, that is generated in a period of plating therefor, at the concave part thereon, and then there may be happened a defect, such as that it is not able to adhere such the plating on such the part thereon, that there may be generated a swelling due to the plating therefor because of the result that there is occurred a convergence of an electric current on a periphery of such the concave part thereon, or the like. Therefore, if there is reduced such the concave component thereon, it is surmised that it becomes able to be decreased an incidence rate for such the defect, and then thereby it becomes able to be improved the ability of plating thereon.
That is to say, in the case where there is less concave components therein on the surface of the material therefor, and also in the case where there is existing the peak position regarding the frequency curve, that represents the concave component in the surface roughness thereon and/or the convex component therein, at the plus side (the side for the convex component) comparing to the average value of the curve for meaning the surface roughness thereon (the position as zero regarding such the frequency curve), it becomes able to be improved the solder wettability on such the material therefor and the ability of plating thereon.

Moreover, according to the present invention, regarding the above mentioned Cu-Ni-Si alloy, there may be contained at least any one of elements to be additional thereinto, that is selected from a group that is comprised of Sn, Zn, Cr and Mg, as between 0.005 mass% and 1.0 mass% in total. Further, there may be contained therein as further preferred to be as between 0.05 mass% and 0.5 mass% in total. That is because such the element to be additional thereinto has an effect on an improvement of such as the withstand stress and relaxation characteristic (the withstand creep rupture property), the bending workability, the adherence of the solder thereon, or the like, in addition to the strength of the final product and the electrical conductivity thereof, without spoiling the advantage according to the present invention for such the Corson alloy.
Still further, regarding such the strength thereof, it is able to superimpose a reinforcement of solid solution with making use of at least any one of Sn, Zn and Mg, in addition to a reinforcement of precipitation regarding the compound of Ni and Si that is the aspect according to the present alloy system.
Still further, regarding such the withstand stress and relaxation characteristic (the withstand creep rupture property), it becomes able to be improved according to the solid solution with making use of at least any one of Sn, Zn and Mg, comparing to that in the case of any additive free materials.
Still further, regarding such the bending workability, it becomes able to be improved such the workability in a case where a size of a grain therein becomes to be fine, and then an addition of Cr functions as demonstrating an effect of refining such the size of the grain therein.
Still further, it is effective to make use of Zn regarding an improvement of the solder wettability thereon, as the same becomes to be segregated at an interface between the solder and a parent phase of Cu, and then as there becomes to have an advantage according to making use thereof that it becomes able to suppress a generation of any void therein, that may be generated due to a change with the lapse of time of the solder and of such the parent phase.
Still further, because there may be interrupted on the electrical conductivity thereof in a case where there is existing excessively a large amount for any one of Sn, Zn, Cr and Mg therein, it is desirable for an addition thereof to be controlled as not higher than 1.0 mass% in total. On the contrary thereto, it is desirable for such the addition thereof to be as not lower than 0.005 mass% in total as well, for demonstrating the above mentioned advantage thereof.
Still further, the Co therein functions to substitute some amount of the above mentioned compound of Ni and Si, and then the same functions to contribute as becoming to be a compound of Ni-Co-Si to the strength thereof. And then in such the case thereof, it is desirable for the content of such the Co to be added thereinto as between 0.5 mass% and 2.0 mass%, and also for becoming the content of such the Co therein and the content of the Ni therein to become as between 1.5 mass% and 4.0 mass% in total thereof.

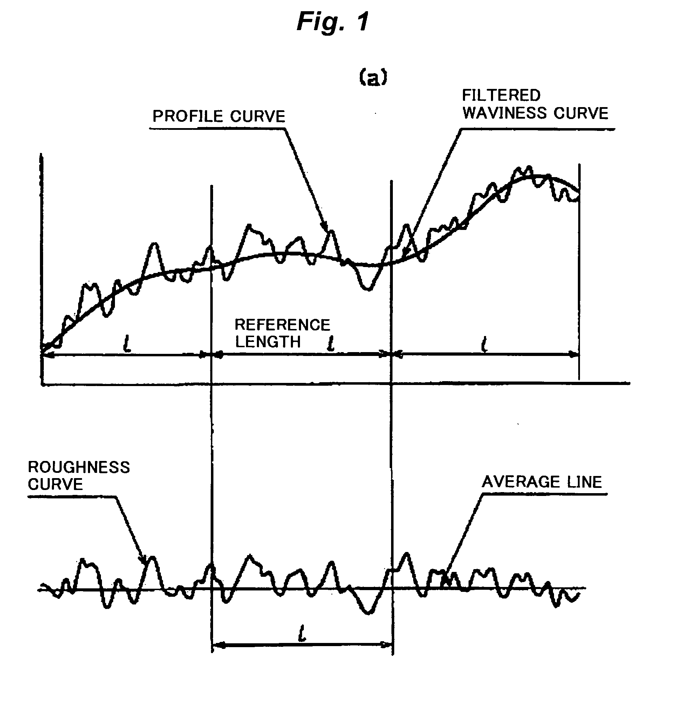

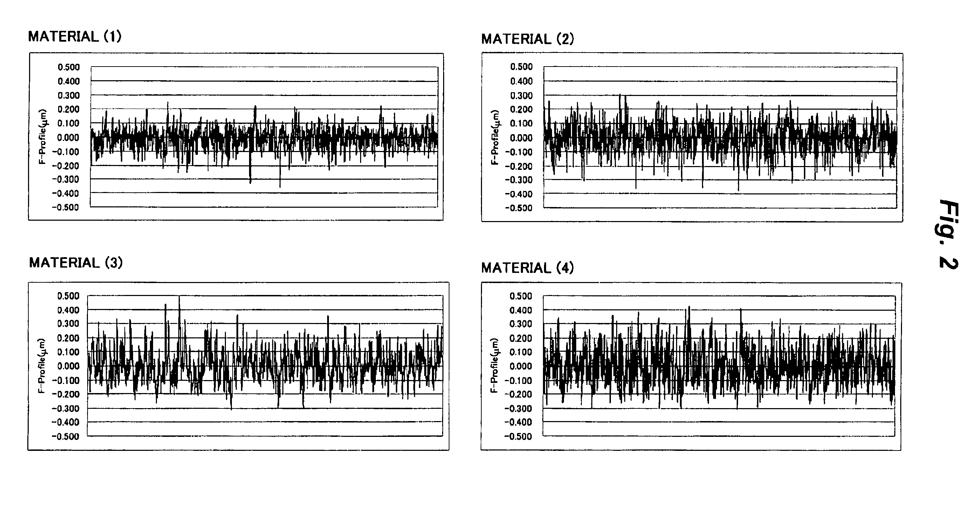

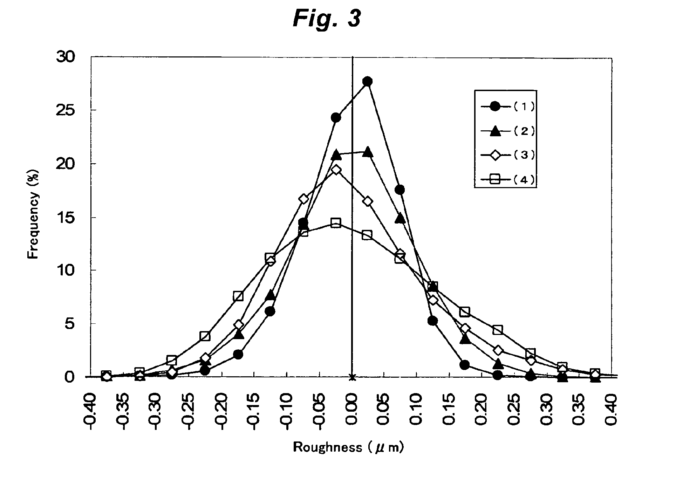

Next, regarding a measurement of the relative roughness on the surface thereof, there is performed such the measurement as pursuant to the definition of a surface roughness and the label thereof (B0601-2001) as defined in the Japanese Industrial Standards (JIS). Moreover, it is one of the points to evaluate an average line thereof, as similar to the method for evaluating such as the Ra thereon, an Rt thereon, the Ry thereon, or the like. Further, according to the above mentioned JIS label, it is able to be evaluated such the average line thereof by making use of a filtered waviness curve. Still further, a component to be come out to an upper side of such the average line thereof is referred to as a convex component hereinafter, meanwhile, a component to be come out to a lower side of such the average line thereof is defined to be as a concave component hereinafter. As more specifically therefor, there is shown in FIG. 1 that is excerpted from FIG. 1 (a) according to the same JIS label. And then according to such the figure, the portion of the roughness curve therein to be come out to the upper side of such the average line therein is defined to be as the convex component therein, meanwhile, the portion thereof to be come out to the lower side thereof is defined to be as the concave component.
Still further, according to such the measurement therefor at this time thereof, there is designed to be measured a relative roughness on a surface of a material therefor in a direction as vertical to a rolling therefor. And then therefor, a sampling length thereof is assumed to be as 4 mm, that is to say, a value to be cut off becomes to be as 0.8 mm (that is pursuant to the above mentioned JIS label). Still further, a rate for scanning thereon is set to be as 0.1 mm/sec. Still further, there is made use of a surface roughness measuring apparatus (Surfcorder SE3500) for such the measurement thereof, that is produced by Kosaka Laboratory Ltd. , and then there becomes to be 7500 points for the number of data obtained by such the measurement due to such the measuring length as 4 mm. And then thereafter, there becomes to be performed for sorting such the data into a component as an upper side (plus) from an average line thereof and into a component as a lower side (minus) therefrom, there becomes to be plotted a frequency distribution thereof, and then there becomes to be performed an assessment therefor.
Still further, according to such the measurement therefor by making use of the above mentioned conditions therefor, there becomes to be existed a material that an average line thereof does not fit to a peak of a frequency distribution therefor, though it is considered therefor in general that the other average lines are the lines for meaning the average of the convex components therein and the concave components therein. For example, there are shown charts ((1), (2), (3), and (4)) in FIG. 2 for showing the relative roughness regarding materials therefor, that are individually produced by following each of a variety of conditions therefor respectively. Still further, there becomes to be sorted the convex components therein and the concave components therein with making use of such the individual charts. And then thereafter, there is performed therefor to be re-plotted, with a vertical axis therein to be redefined as a frequency (%) thereof and a horizontal axis therein to be redefined as a roughness (µm) thereon respectively. Hence, there becomes to be obtained FIG. 3 thereby. And then according to such the plot, there becomes to be existed the material that has the peak of the frequency thereof at the concave component therein (the minus side), the material that has the peak thereof at the convex component therein (the plus side), and the material that has the peak thereof at approximately zero, in a case of drawing a line for passing through the roughness as zero µm on the horizontal axis therein.
Furthermore, the present inventors have been directing their attention to the material (1) according to such FIG. 3, that has the peak thereof as existing at the side thereof as the convex component therein, and that becomes to be superior in the solder wettability thereon and in the ability of plating thereon as well. And then according thereto, there becomes to be presented the present invention hereby.

Thus, according to the present invention, by forming the Cu-Ni-Si alloy, and also by performing further the addition of at least any one of Sn, Zn, Cr, Mg and Co thereinto, it becomes able to provide the copper alloy, that is superior in such as the strength thereof, the electrical conductivity thereof, the withstand stress and relaxation characteristic (the withstand creep rupture property), the bending workability, the adherence of the solder thereon, or the like, and that becomes to be applicable as preferred to the application of the electrical machinery and apparatus and of the electronic equipment.

### Examples

Next, the present invention will be described in further detail below, with reference to the following examples, however, the present invention will not be limited to any one of such the examples.

### (Example 1)

First of all, there is performed a dissolution for an alloy, that contains the components as shown in Table 1, and that is comprised of Cu and an unavoidable impurity as the remaining percentage thereof, by making use of a high frequency melting furnace, and then thereafter there becomes to be casted by making use of such the alloy with a rate of cooling therefor as between 10°C per second and 30°C per second. Hence, it becomes able to obtain an ingot, which has a thickness as 30 mm, a width as 100 mm and a length as 150 mm.
And then thereafter, there is performed to be maintained such the ingot, that is obtained thereby, at between 930°C and 970°C for between a half hour and one hour. Next, there becomes to be performed a hot rolling therefor to form a hot rolled strip with having a strip thickness of a t as 12 mm, and then thereafter there becomes to be performed a facing for both surfaces of such the strip to become the t thereof as 10 mm. Next, there becomes to be performed a finishing therefor to become the t thereof as 0.3 mm by making use of a cold rolling therefor.
Next, regarding Process group A therein, there is performed a heat treatment therefor at between 425°C and 500°C for between one hour and four hours, and then thereafter there becomes to be performed a sorting therefor into Treatment (1): a material that there is performed an acid cleaning for a surface thereof; Treatment (2) : a material that there is performed to be degreased therefrom; and Treatment (3): a material that there is not performed either one of such the treatments therefor at all. And then thereafter there becomes to be performed a finishing rolling therefor. Thus, it becomes able to be produced each of the materials therefor. Moreover, for Treatment (1) there is made use of an aqueous solution of a sulfuric acid as 10% therein, for Treatment (2) there is made use of hexane, and also there is designed an amount of time for soaking each of thereinto to be as between ten seconds and thirty seconds respectively.
Further, regarding Process group B, there is performed a process of a solution heat treatment for a strip of a t as 0.3 mm at between 850°C and 950°C for between ten seconds and thirty seconds. And then immediately thereafter there becomes to be performed a process of a water quenching therefor. Next, there becomes to be performed a process of the heat treatment therefor at between 425°C and 500°C for between one hour and four hours, as similar to Process group A, and then thereafter there becomes to be performed the sorting such the strips into Treatments (1), (2) and (3). And then thereafter there becomes to be performed a process of the finishing rolling for each thereof respectively (regarding a roughness on each of the surfaces of the rolling mill rolls therefor, there is made use each thereof with having the Ra as 0.03 µm and the Ry as 0.3 µm for Process group A, on the contrary thereto, there is made use the other one thereof with having the Ra as 0.06 µm and the Ry as 0.71 µm for Process group B, respectively). Thus, it becomes able to be produced each of such the materials therefor.
And then at last, with making use of the rolling mill roll as similar thereto for a process of the finishing rolling for each thereof, there becomes to be performed such the process with a rate of the finishing therefor such as 10%, 20%, 30%, or the like. Furthermore, there may become to be performed as required an annealing at a lower temperature at between 300°C and 450°C. And then thereafter there becomes to be performed a test for characteristics regarding each of such the sample materials.

Next, for each of such the sample materials, there is performed an examination on the characteristics thereof as described below.

### a. Relative roughness

There is performed a measurement for a material in a direction as vertical to a rolling therefor. Moreover, there is performed such the measurement as pursuant to JIS-B0601 (2001). Further, a length of the measurement therefor is set to be as 4 mm, a value of to be cut off thereof is set to be as 0.8 mm (that is pursuant to the above mentioned JIS label), and a rate for scanning thereon is set to be as 0.1 mm/sec. Still further, there is made use of the surface roughness measuring apparatus (Surfcorder SE3500) for such the measurement therefor, that is produced by Kosaka Laboratory Ltd. Still further, there is repeated such the measurement therefor with the number thereof as three times, and then there becomes to be evaluated each of the averages for the Ra and for the Ry respectively. Furthermore, regarding a convex component therein and a concave component therein, there becomes to be formed the graph as shown in FIG. 3 with making use of the data of the measurement therefor as three times thereof, and then there becomes to be judged according to a confirmation whether a peak thereof exists at an upper (plus) component therein comparing to a line, that indicates the roughness thereon as zero µm, or at a lower (minus) component therein. And then in a case where there is existed a dispersion according to such the measurements as between the three times thereof, for example, in a case where there are existed the peaks at the upper side (plus) component therein according to such the measurements as the two times thereof, there becomes to be judged that there is an amount for the convex components as larger comparing thereto.

### b. Solder wettability

There is performed a measurement as pursuant to JIS-C0053 (1996). Moreover, there is made use of the solder checker (SAT-5000), that is produced by RHESCA Co., Ltd., for such the measurement thereof, and then there becomes to be performed thereof with a depth for soaking thereinto as 5 mm, a rate for soaking thereinto as 25 mm/sec, and an amount of time for soaking thereinto as 10 seconds. Further, regarding an assessment therefor, there becomes to be performed such the assessment to be as four classification therefor, that a result of the assessment therefor is defined to be as making use of a symbol as "double circle (excellent)" in a case where a zero cross time of a meniscograph is shorter than three seconds, that a result of the assessment therefor is defined to be as making use of a symbol of "O (good)" in a case where the zero cross time thereof is not shorter than three seconds but shorter than six seconds, that a result of the assessment therefor is defined to be as making use of a symbol as "Δ (acceptable)" in a case where the zero cross time thereof is not shorter than six seconds but shorter than nine seconds, and that a result of the assessment therefor is defined to be as making use of a symbol as "X (no good)" in a case where the zero cross time thereof is not shorter than nine seconds.

### C. Ability of plating

There is performed a plating with making use of silver with a thickness thereof to become as 1 µm, and then there is performed an assessment therefor. Moreover, regarding a surface preparation therefor, there is performed to be degreased therefrom with making use of acetone, and then thereafter there is performed to be degreased further therefrom by making use of a cathodic electrolysis with an electric current density as 2.5 A/dm² in an aqueous solution of sodium hydroxide as 10% therein for approximately thirty seconds. Further, there becomes to be performed thereafter an acid cleaning therefor in a dilute sulfuric acid (10%) for approximately thirty seconds. And then thereafter there becomes to be performed such the plating with having an area thereon to become as twenty mm times fifty mm. Still further, regarding such the plating of silver thereon, there becomes to be performed therefor under a condition that the electric current density therefor is set to be as 1.0 A/dm² at a room temperature therefor, in a plating solution that includes potassium silver cyanide as 55 g/l, potassium cyanide as 75 g/l, potassium hydroxide as 10 g/l, and potassium carbonate as 25 g/l. And then after such the plating thereon, there becomes to be performed the assessment by observing any failure on such the plated surface thereof by making use of an optical microscope with a magnification thereof as fifty times therefor. Still further, regarding such the observation thereof, there is performed therefor by selecting three parts on such the plated surface thereof as arbitrarily therefor (so as not to be selected any edge parts on each of the test pieces for testing such the plating) with an area as ten mm times ten mm for each thereof respectively. Still further, there becomes to be counted the number of pieces for such as the swelling due to the plating thereon (with having a diameter thereof as not less than 5 µm), the part that there becomes not to be plated thereon (the defect), or the like. And then there becomes to be obtained as the assessment therefor by summing up such the number of defects thereon that are found out at such the individual three parts thereon. Furthermore, regarding criteria for such the assessment thereof, there are defined to be as making use of the symbol of "○" in a case where a summation of the failures in such the individual three parts thereon is between zero and five pieces, to be as making use of the symbol as "Δ" in a case thereof as between six and twenty pieces therein, and to be as making use of the symbol as "X" in a case thereof as not less than twenty-one pieces therein.

(Table 1)

| TABLE 1: Component in experimental material (mass %) | | | | | | | | |
|---|---|---|---|---|---|---|---|---|
| | Ni | Si | Sn | Zn | Mg | Cr | Co | Cu |
| 1 | 2. 3 | 0. 55 | 0. 15 | 0. 5 | 0. 1 | --- | --- | Bal. |
| 2 | 2. 3 | 0. 65 | 0. 1 | 0. 5 | 0. 1 | 0. 15 | --- | Bal. |
| 3 | 2. 8 | 0. 7 | --- | --- | 0. 12 | --- | --- | Bal. |
| 4 | 3. 0 | 0. 8 | --- | --- | 0. 1 | --- | --- | Bal. |
| 5 | 3. 25 | 0. 8 | 0. 1 | 0. 1 | 0. 1 | --- | --- | Bal. |
| 6 | 3. 5 | 0. 85 | 0. 15 | 0. 05 | --- | --- | --- | Bal. |
| 7 | 3. 75 | 0. 88 | 0. 5 | 0. 1 | 0. 05 | --- | --- | Bal. |
| 8 | 3. 75 | 0. 9 | 0. 15 | 0. 1 | 0. 05 | 0. 1 | --- | Bal. |
| 9 | 3. 75 | 0. 9 | 0. 2 | 0. 5 | --- | 0. 15 | --- | Bal. |
| 10 | 3. 9 | 0. 9 | 0. 1 | 0. 5 | 0. 15 | --- | --- | Bal. |
| 11 | 2. 5 | 0. 58 | --- | --- | --- | --- | --- | Bal. |
| 1 2 | 1. 5 | 0. 6 | --- | --- | --- | --- | 1. 1 | Bal. |
| 13 | 2. 0 | 0. 55 | --- | --- | --- | --- | 0. 5 | Bal. |
| 14 | 2. 1 | 0. 65 | 0. 15 | 0. 5 | --- | 0. 2 | 0. 8 | Bal. |
| 15 | 2. 4 | 0. 7 | 0. 07 | 0. 5 | 0. 15 | --- | 1. 0 | Bal. |

(Table 2-1)

**TABLE 2-1**

| ALLOY | PROCESS | TREATMENT | Ra (µm) | Ry (µm) | PEAK POSITION | SOLDER WETTABILITY | ABILITY OF PLATING |
|---|---|---|---|---|---|---|---|
| 1 | GROUP A | (1) | 0. 09 | 0. 99 | + | ⊚ | ○ |
| | | (2) | 0. 09 | 0. 84 | + | ⊚ | ○ |
| | | (3) | 0. 08 | 1. 01 | 0 | ○ | Δ |
| | GROUP B | (1) | 0. 17 | 1. 80 | + | ○ | ○ |
| | | (2) | 0. 14 | 1. 60 | + | ○ | ○ |
| | | (3) | 0. 22 | 2. 38 | 0 | Δ | Δ |
| 2 | GROUP A | (1) | 0. 08 | 1. 01 | + | ⊚ | ○ |
| | | (3) | 0. 08 | 1. 15 | - | Δ | × |
| | GROUP B | (1) | 0. 29 | 2. 70 | + | ○ | ○ |
| | | (3) | 0. 15 | 1. 59 | 0 | Δ | Δ |
| 3 | GROUP A | (1) | 0. 10 | 0. 94 | + | ⊚ | ○ |
| | | (2) | 0. 09 | 0. 81 | + | ⊚ | ○ |
| | | (3) | 0. 08 | 0. 95 | 0 | Δ | Δ |
| | GROUP B | (1) | 0. 17 | 1. 77 | + | ○ | ○ |
| | | (2) | 0. 15 | 1. 54 | + | ○ | ○ |
| | | (3) | 0. 22 | 2. 36 | - | × | × |
| 4 | GROUP A | (2) | 0. 08 | 1. 00 | + | ⊚ | ○ |
| | | 3) | 0. 09 | 1. 08 | 0 | ○ | Δ |
| | GROUP B | (2) | 0. 28 | 2. 77 | + | ○ | ○ |
| | | (3) | 0. 15 | 1. 58 | 0 | Δ | Δ |
| 5 | GROUP A | (1) | 0. 08 | 1. 02 | + | ⊚ | ○ |
| | | (3) | 0. 09 | 1. 16 | - | Δ | × |
| | GROUP B | (1) | 0. 28 | 2. 68 | + | ○ | ○ |
| | | (3) | 0. 16 | 1. 60 | 0 | Δ | Δ |
| 6 | GROUP A | (2) | 0. 08 | 1. 01 | + | ⊚ | ○ |
| | | (3) | 0. 09 | 1. 13 | - | Δ | × |
| | GROUP B | (2) | 0. 28 | 2. 63 | + | ○ | ○ |
| | | (3) | 0. 15 | 1. 62 | - | Δ | × |
| 7 | GROUP A | (1) | 0. 09 | 1. 01 | + | ⊚ | ○ |
| | | (3) | 0. 09 | 1. 11 | 0 | ○ | Δ |
| | GROUP B | (1) | 0. 28 | 2. 77 | + | ○ | ○ |
| | | (3) | 0. 15 | 1. 68 | - | Δ | × |
| 8 | GROUP A | (1) | 0. 09 | 1. 00 | + | ⊚ | ○ |
| | | (2) | 0. 09 | 0. 95 | + | ⊚ | ○ |
| | | (3) | 0. 08 | 0. 99 | - | Δ | × |
| | GROUP B | (1) | 0. 18 | 1. 78 | + | ○ | ○ |
| | | (2) | 0. 15 | 1. 64 | + | ○ | ○ |
| | | (3) | 0. 22 | 2. 25 | - | × | × |
| 9 | GROUP A | (1) | 0. 07 | 1. 04 | + | ⊚ | ○ |
| | | (3) | 0. 09 | 1. 04 | 0 | ○ | Δ |
| | GROUP B | (1) | 0. 28 | 2. 68 | + | ○ | ○ |
| | | (3) | 0. 15 | 1. 62 | 0 | Δ | Δ |
| 10 | GROUP A | (1) | 0. 09 | 0. 97 | + | ⊚ | ○ |
| | | (3) | 0. 09 | 1. 13 | - | Δ | × |
| | GROUP B | (1) | 0. 28 | 2. 76 | + | ○ | ○ |
| | | (3) | 0. 15 | 1. 60 | 0 | Δ | Δ |

(Table 2-2)

**TABLE 2-2 (subsequent to TABLE 2-1)**

| ALLOY | PROCESS | TREATMENT | Ra (µm) | Ry (µm) | PEAK POSITION | SOLDER WETTABILITY | ABILITY OF PLATING |
|---|---|---|---|---|---|---|---|
| 11 | GROUP A | (1) | 0. 09 | 1. 07 | + | ⊚ | O |
| | | (2) | 0. 08 | 1. 30 | 0 | Δ | × |
| | GROUP B | (1) | 0. 28 | 2. 61 | + | ⊚ | ○ |
| | | (2) | 0. 25 | 1. 69 | - | Δ | ○ |
| 12 | GROUP A | (1) | 0. 08 | 0. 99 | + | ⊚ | ○ |
| | | (3) | 0. 09 | 1. 22 | - | Δ | Δ |
| | GROUP B | (1) | 0. 22 | 1. 76 | + | ⊚ | ○ |
| | | (3) | 0. 18 | 2. 62 | - | Δ | Δ |
| 13 | GROUP A | (1) | 0. 10 | 1. 07 | + | ○ | ○ |
| | | (2) | 0. 10 | 1. 03 | 0 | Δ | × |
| | GROUP B | (1) | 0. 28 | 1. 99 | + | ○ | ○ |
| | | (2) | 0. 12 | 2. 02 | 0 | Δ | × |
| 14 | GROUP A | (1) | 0. 10 | 1. 37 | + | ○ | ○ |
| | | (3) | 0. 09 | 1. 34 | 0 | Δ | × |
| | GROUP B | (1) | 0. 29 | 1. 76 | + | ○ | ○ |
| | | (3) | 0. 12 | 1. 90 | - | Δ | × |
| 15 | GROUP A | (1) | 0. 10 | 0. 47 | + | ○ | ○ |
| | | (2) | 0. 11 | 0. 73 | - | Δ | × |
| | GROUP B | (1) | 0. 29 | 2. 96 | + | ○ | ○ |
| | | (2) | 0. 21 | 2. 60 | - | Δ | × |

### Industrial Applicability

Such an copper alloy strip material according to the present invention becomes to be applicable as preferred to such as a lead frame for an electrical machinery and apparatus and for an electronic equipment, a connector therefor, a material for a terminal therefor, or the like, and further to an electrical and an electronic components, such as a connector or a material for a terminal for mounting on a motor vehicle, a relay therefor, a switch therefor, or the like.

Thus, there is described as above regarding the present invention with the embodiment therefor, however, the present invention will not be limited to every detail of the description as far as a particular designation therefor, and it should be interpreted widely without departing from the spirit and scope of the present invention as disclosed in the attached claims.

Furthermore, the present invention claims the priority based on Japanese Patent Application No. 2007-260397, that is patent applied in Japan on the third of October, 2007, and the entire contents of which are expressly incorporated herein by reference.

## Claims

1. An copper alloy strip material for electrical/electronic components, including:
Ni as between 1.5 mass% and 4.0 mass%;
Si as between 0.3 mass% and 1.5 mass%; and
a remaining percentage thereof to be comprised of Cu and an unavoidable impurity,
wherein a mean roughness Ra of a surface roughness is not larger than 0.3 µm regarding the strip in a direction as right angle to a direction of a rolling therefor,
a maximum height Ry thereof is not higher than 3.0 µm regarding the same therein, and
there is positioned a peak position regarding a frequency curve, that represents a concave component of the surface roughness and/or a convex component thereof, at the plus side (the side for the convex component) comparing to an average value of the curve for meaning the surface roughness.

2. An copper alloy strip material for electrical/electronic components, further including:
Co as between 0.5 mass% and 2.0 mass%;
Ni and Co in total as between 1.5 mass% and 4.0 mass%;
Si as between 0.3 mass% and 1.5 mass%; and
a remaining percentage thereof to be comprised of Cu and an unavoidable impurity,
wherein a mean roughness Ra of a surface roughness is not larger than 3µm regarding the strip in a direction as right angle to a direction of a rolling therefor,
a maximum height Ry thereof is not higher than 3µm regarding the same therein, and
there is positioned a peak position regarding a frequency curve, that represents a concave component of the surface roughness and/or a convex component thereof, at the plus side (the side for the convex component) comparing to an average value of the curve for meaning the surface roughness.

3. The copper alloy strip material for electrical/electronic components as defined in claim 1 or 2,
wherein the copper alloy includes at least any one of elements, that is selected from a group comprised of Sn, Zn, Cr and Mg, as between 0.005 mass% and 1.0 mass% in total.
